# EUROPÄISCHE PATENTANMELDUNG

(11) **EP 1 170 781 A1**
(43) Veröffentlichungstag der Anmeldung: **09.01.2002**
(21) Anmeldenummer: 00810578.5
(22) Anmeldetag: 03.07.2000
(51) Int. Cl.: H01L 21/00

(54) **Greifwerkzeug**

(71) Anmelder: Esec Trading S.A., 6330 Cham (CH)
(72) Erfinder: Ulrich, René Josef, 6353 Weggis (CH)
(74) Vertreter: Falk, Urs, Dr.

(57) **Zusammenfassung**

Ein Greifwerkzeug zum Montieren von Halbleiterchips auf einem Substrat weist ein Saugorgan auf, das aus einer Platte (4) aus einem formstabilen Material besteht, deren eine Oberfläche (5) mit Strukturen (6) aus einem ausgehärteten Klebstoff versehen ist. Als Material für die Platte (4) dient z.B. Aluminium, ein Kohlefaserverbundwerkstoff oder ein formstabiler Kunststoff. Als Material für die Strukturen (6) eignet sich z.B. ein Klebstoff, der Teflon® als Füllmaterial aufweist.

## Beschreibung

Die Erfindung betrifft ein Greifwerkzeug zum Montieren von Halbleiterchips auf einem Substrat. Solche Greifwerkzeuge sind bekannt unter den Fachbegriffen "die collet" oder "die bonding tool".

Bei der Montage von Halbleiterchips werden die aus einem Wafer gesägten und auf einer Folie haftenden Halbleiterchips vom Greifwerkzeug ergriffen und auf einem Substrat plaziert. Ein solches Greifwerkzeug besteht im wesentlichen aus einem Metallschaft und einem daran befestigten Saugorgan, das einen gegen das zu ergreifende Bauteil gerichteten, über eine Bohrung mit Vakuum beaufschlagbaren Hohlraum aufweist. Sobald das Saugorgan auf dem Bauteil aufliegt, bewirkt das Vakuum die Haftung des Bauteils am Saugorgan.

Die Befestigung des Halbleiterchips auf dem Substrat erfolgt je nach Anwendungsbereich mit unterschiedlichen Klebematerialien. Neben Weichlot, bei dem der Halbleiterchip auf das Substrat aufgelötet wird, und Klebefolie kommen hauptsächlich elektrisch leitende, Silber enthaltende, als auch elektrisch nicht leitende, flüssige Klebstoffe auf Epoxybasis zur Anwendung. Neuerdings sind aber auch Klebstoffe bekannt geworden, die auf neuen Molekularsystemen beruhen, die in vergleichsweise viel kürzerer Zeit aushärten. Die Klebstoffschicht muss einerseits die Haftung des Halbleiterchips auf dem Substrat gewährleisten, andererseits muss sie in der Lage sein, Schubspannungen, die beispielsweise durch Temperaturschwankungen bedingt sind, auszugleichen. Da die Eigenschaften der genannten Klebstoffe stark von ihrer Schichtdicke abhängen, ist eine gleichbleibende Klebstoffschichtdicke in engen Grenzen erforderlich, um zuverlässige Produkte mit identischen Eigenschaften herstellen zu können.

Um auch minimalste Verletzungen des Halbleiterchips bei der Montage zu vermeiden, werden Greifwerkzeuge verwendet, deren Saugorgan aus Gummi besteht. Gummi hat zusätzlich den Vorteil, dass es die Hohlkammer gut abdichtet, so dass der Halbleiterchip mit relativ grosser Ansaugkraft von der Folie abgelöst werden kann.

Diese Gummiwerkzeuge haben jedoch den schwerwiegenden Nachteil, dass sie nicht mit ausreichender Präzision hergestellt werden können. Die Gummiwerkzeuge sind in der Regel 2 bis 3 mm dick. Für die Herstellung werden teure Spritzwerkzeuge benötigt. Trotzdem weisen die fertigen Gummiwerkzeuge in der Dicke Schwankungen von 50µm und mehr auf. In der Folge treten insbesondere bei der Montage vergleichsweise grosser Halbleiterchips, also bei Halbleiterchips mit einer Kantenlänge von 20 mm und mehr, Probleme auf, weil der Klebstoff unter dem Halbleiterchip schlecht verteilt ist, Luftblasen einschliesst, nicht überall bis zu den Kanten des Halbleiterchips fliesst, ungleichmässig dick ist, etc.

Der Erfindung liegt die Aufgabe zugrunde, ein Greifwerkzeug zu entwickeln, das eine problemlose Montage grosser Halbleiterchips ermöglicht.

Die genannte Aufgabe wird erfindungsgemäss gelöst durch die Merkmale des Anspruchs 1.

Die Lösung der Aufgabe gelingt erfindungsgemäss dadurch, dass das Greifwerkzeug eine Saugplatte aus formstabilem Material aufweist, deren eine, dem Halbleiterchip zugewandte, Oberfläche Strukturen aus einem aushärtbaren Klebstoff aufweist. Als Klebstoff dient ein in der Halbleiterindustrie bewährter und akzeptierter Klebstoff. Die Saugplatte gewährleistet die Steifigkeit bzw. Formstabilität des Greifwerkzeugs. Die Strukturen aus ausgehärtetem Klebstoff garantieren die nötige Elastizität, damit der Halbleiterchip nicht verkratzt wird und damit der zwischen dem Greifwerkzeug und dem Halbleiterchip gebildete Hohlraum vakuumdicht wird.

Nachfolgend wird ein Ausführungsbeispiel der Erfindung anhand der Zeichnung näher erläutert.

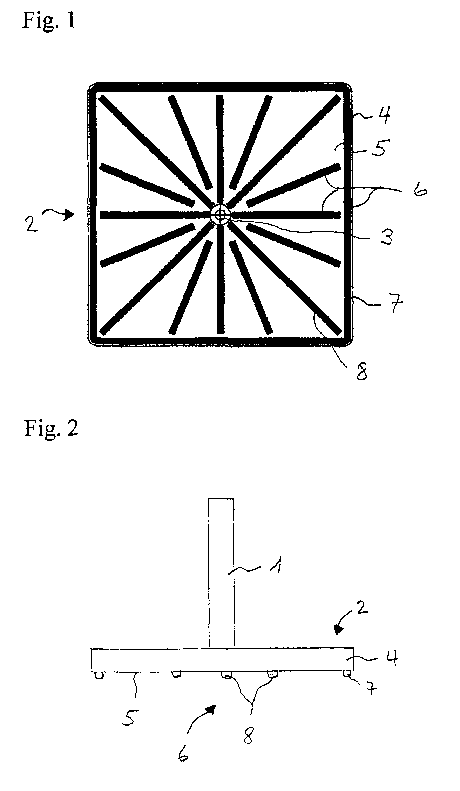

Es zeigen: Fig. 1 und 2 ein Greifwerkzeug.

Die Fig. 1 und 2 zeigen zeigen in Aufsicht und im Querschnitt ein Greifwerkzeug, das einen Schaft 1 und als eigentliches Saugorgan eine Saugplatte 2 aus einem formstabilen Material umfasst. Der Schaft 1 ist so ausgebildet, dass die Saugplatte 2 stabil und rechtwinklig zur Längsachse des Schaftes 1 gehalten wird. Vorzugsweise ist die Saugplatte 2 nicht nur auf den Schaft 1 aufgepresst, sondern zusätzlich mit einem thermisch schnellaushärtenden Kleber fixiert. Die Saugplatte 2 weist im Zentrum eine über den Schaft 1 mit einer Vakuumquelle verbindbare Bohrung 3 auf.

Die Saugplatte 2 besteht aus einer etwa zwei Millimeter dicken formstabilen Platte 4, deren eine Oberfläche 5 mit Strukturen 6 aus einem in der Halbleiterindustrie bewährten Material versehen ist. Als Material für die Platte 4 dient vorzugsweise eloxiertes Aluminium. Eloxiertes Aluminium bietet gegenüber nicht eloxiertem Aluminium den Vorteil der Korrosionsbeständigkeit. Die Platte 4 kann aber auch aus einem Kohlefaserverbundwerkstoff oder einem formstabilen Kunststoff gefertigt sein. Eine Platte 4 aus Kunststoff lässt sich beispielsweise preisgünstig im Spritzgussverfahren herstellen. Sowohl Kohlefaserverbundwerkstoffe als auch Kunststoffe weisen gegenüber Metallen den Vorteil des geringeren Gewichts bei trotzdem ausreichender oder sogar grösserer Formstabilität auf. Als Material für die Strukturen 6 dient ein schnell aushärtender Klebstoff, der als Füllmaterial vorzugsweise einen grossen Anteil an Teflon® enthält. Ein solches Material ist beispielsweise unter der Bezeichnung QM1536 von der Firma Dexter erhältlich. Das Material QM1536 ist ein elektrischer Isolator und hat einen Elastizitätsmodul von 300 MPa. Die Strukturen 6 sind somit elastisch genug, dass sie den Halbleiterchip nicht verkratzen. Es ist auch möglich, für die Strukturen 6 einen elektrisch leitenden Klebstoff zu verwenden, der im Betrieb entweder direkt oder über die in diesem Fall vorzugsweise nicht eloxierte Platte 4 mit Erde verbunden ist. Ein geeignetes Material ist unter der Bezeichnung QM1506 von der Firma Dexter erhältlich. Es enthält Silber als Füllmaterial und weist einen Elastizitätsmodul von 630 MPa auf.

Die Aluminiumplatte 4 kann in verschiedenen Farben ausgeführt sein. Die eloxierte Aluminiumplatte 4 bietet eine optimale Oberfläche für die Strukturen 6. Die Strukturen 6 umfassen eine geschlossene Berandungslinie 7, sowie sternförmig vom Zentrum der Aluminiumplatte 4 ausgehende Abstützlinien 8. Die Höhe der Strukturen 6 beträgt typisch etwa 0.2 mm. Um eine hohe Konstanz der Höhe der Strukturen 6 zu erreichen, wird der Klebstoff zunächst mit einem Schreibkopf in einer Dicke von etwa 0.25 mm aufgetragen, ausgehärtet und dann planparallel zur Oberfläche der Aluminiumplatte 4 um etwa 0.05 mm abgeschliffen.

Die Berandungslinie 7 der Strukturen 6 hat die Aufgabe, die durch die Aluminiumplatte 4, die Berandungslinie 7 und den gegriffenen Halbleiterchip gebildete Vakuumzone abzudichten. Die Abstützlinien 8 haben die Aufgabe, den Halbleiterchip abzustützen und zu verhindern, dass sich der Halbleiterchip beim Absetzen auf das Substrat verbiegt. Die Strukturen 6 müssen zudem aus einem Material gefertigt sein, das einerseits jegliche Beschädigung des Halbleiterchips ausschliesst und andererseits unter keinen Umständen Rückstände auf der Chipoberfläche hinterlässt.

Das erfindungsgemässe Greifwerkzeug weist die folgenden Vorteile auf:
- Die Steifigkeit bzw. Formstabilität des Greifwerkzeugs ist markant höher als bei einem herkömmlichen Greifwerkzeug mit einem Saugorgan aus Gummi. Die Abstützlinien 8 verhindern, dass sich der Halbleiterchip beim Absetzen auf das Substrat verbiegt. Der Klebstoff breitet sich daher gleichmässig unter dem Halbleiterchip aus und es bildet sich eine Klebstoffschicht konstanter Dicke, die frei von Lufteinschlüssen ist.
- Die Strukturen 6 selbst haften nicht am Halbleiterchip. Nach dem Ausschalten des Vakuums bleibt der Halbleiterchip lagegenau auf der auf das Substrat aufgebrachten Klebstoffportion liegen.
- Die geringe Höhe der Strukturen 6 hat zur Folge, dass das Volumen der zwischen dem Halbleiterchip und der Aluminiumplatte 4 gebildeten Hohlkammer sehr klein ist, so dass der Kraftaufbau beim Aufbau des Vakuums und der Kraftabfall beim Lösen des Vakuums sehr schnell erfolgen.
- Selbst für die grössten Chipabmessungen ergeben sich schlanke und sehr leichte Greifwerkzeuge.

Es ist von Vorteil, sofern die Vakuumhaltekraft gross genug ist, die Abmessungen des Greifwerkzeugs kleiner, typischerweise um etwa 70%, zu bemessen als die Abmessungen des Halbleiterchips. Auf diese Weise kann erreicht werden, dass sich der Rand des Halbleiterchips, vom Zentrum des Saugorgans her gesehen, immer nach oben durchbiegt. Das Resultat sind eine perfekte Ausbreitung des Klebstoffes bis an die Kanten des Halbleiterchips, sowie die nachträgliche Ausbildung des Fillet mit genügend Klebstoff und ohne Lufteinschlüsse.

Das Greifwerkzeug eignet sich auch für kleine Halbleiterchips. Allerdings können dann die Abstützlinien 8 entfallen.

## Patentansprüche

1. Greifwerkzeug mit einem Saugorgan zum Montieren von Halbleiterchips auf einem Substrat, **dadurch gekennzeichnet, dass** das Saugorgan eine Platte (4) aus einem formstabilen Material ist, deren eine Oberfläche (5) mit Strukturen (6) aus einem ausgehärteten Klebstoff versehen ist.

2. Greifwerkzeug nach Anspruch 1, **dadurch gekennzeichnet, dass** die Platte (4) aus Aluminium ist, deren eine Oberfläche (5) eloxiert ist.

3. Greifwerkzeug nach Anspruch 1, **dadurch gekennzeichnet, dass** die Platte (4) aus einem Kohlefaserverbundwerkstoff besteht.

4. Greifwerkzeug nach Anspruch 1, **dadurch gekennzeichnet, dass** die Platte (4) aus Kunststoff besteht.

5. Greifwerkzeug nach einem der vorhergehenden Ansprüche 1 bis 4, **dadurch gekennzeichnet, dass** die Strukturen (6) eine Berandungslinie (7) und Abstützlinien (8) umfassen.
